Europäisches Patentamt

European Patent Office

Office européen des brevets

(11) Veröffentlichungsnummer: **0 327 682**
**A1**

## (12) EUROPÄISCHE PATENTANMELDUNG

(21) Anmeldenummer: 88118089.7

(22) Anmeldetag: 31.10.88

(51) Int. Cl.4: **H03F 3/217**

(30) Priorität: 06.02.88 DE 3803583

(43) Veröffentlichungstag der Anmeldung:
16.08.89 Patentblatt 89/33

(84) Benannte Vertragsstaaten:
CH DE FR GB LI

(71) Anmelder: **Licentia Patent-Verwaltungs-GmbH**
**Theodor-Stern-Kai 1**
**D-6000 Frankfurt/Main 70(DE)**

(72) Erfinder: **Beeken, Horst, Dipl.-Ing.(FH)**
**Teltowerstrasse 14**
**D-1000 Berlin 20(DE)**
Erfinder: **Zeis, Jürgen, Dipl.-Ing.(FH)**
**Tutzinger Strasse 19**
**D-1000 Berlin 49(DE)**

(74) Vertreter: **Schulze, Harald Rudolf, Dipl.-Ing.**
**Licentia Patent-Verwaltungs-GmbH**
**Theodor-Stern-Kai 1**
**D-6000 Frankfurt/Main 70(DE)**

(54) **Schaltverstärker zur digitalen Leistungsverstärkung.**

(57) Der Schaltverstärker besteht aus einer Reihenschaltung mehrerer gleichartiger Schaltverstärker-Grobstufen (21-2N), einer pulsdauermodulierten Schaltverstärker-Feinstufe (2F) und einer Schaltverstärker-Shiftstufe (2S), die alle unabhängig voneinander ansteuerbar sind. Eine Steuerung verhindert durch gezieltes Umschalten der Shiftstufe ein zu häufiges Umschalten von Grobstufen bei fehlender oder geringer Eingangssignaländerung und sorgt für schnelle Kompensation bei Grobstufen-Ausfällen.

FIG. 1

EP 0 327 682 A1

## Schaltverstärker zur digitalen Leistungsverstärkung

Die Erfindung betrifft einen Schaltverstärker zur digitalen Leistungsverstärkung gemäß dem Oberbegriff des Patentanspruchs 1. Ein solcher Schaltverstärker ist beispielsweise aus der DE-30 44 956 A1 bekannt.

Der bekannte Schaltverstärker enthält einen Leistungs- und einen Steuerungsteil. Der Leistungsteil besteht aus mehreren gleichartigen Schaltverstärkerstufen (Grobstufen) sowie einer weiteren Schaltverstärkerstufe (Feinstufe), die ausgangsseitig in Reihe geschaltet sind und unabhängig voneinander ein- bzw. ausschaltbar sind. Eine solche Schaltverstärkerstufe enthält eine Gleichspannungsquelle die durch einen steuerbaren Schalter ein- oder ausgeschaltet werden kann. Der Steuerungsteil unterteilt den Eingangssignalbereich in eine der Anzahl der Grobstufen entsprechende Zahl von gleichen Spannungsstufen. Um das analoge Eingangssignal in seiner Leistung digital zu verstärken, wird im Steuerungsteil fortlaufend das Eingangssignal abgetastet und ausgangsseitig entsprechend den abgetasteten Momentanwerten des Eingangssignals Steuerbefehle in der Weise an die Schaltverstärkerstufen abgegeben, daß bei einer Änderung der Amplitude des Eingangssignals um eine Spannungsstufe nach oben bzw. unten sich entsprechen eine Grobstufe in der Reihenschaltung ein- bzw. ausschaltet und daß bei Nichtübereinstimmung der geänderten Amplitude des Eingangssignals mit einer der vorgegebenen Spannungsstufen sich die Feinstufe in Abhängigkeit von der Differenz zwischen der geänderten Amplitude des Eingangssignals und der ihr am nächsten liegenden kleineren Spannungsstufe pulsdauermoduliert ein- und ausschaltet.

Aus der Druckschrift ist weiterhin bekannt, daß eine solche Schaltverstärkerstufe aus einer Gleichspannungsquelle beispielsweise in Form einer primärseitig an das Versorgungsnetz angeschlossene Transformatorschaltung mit sekundärseitig nachgeschalteter Gleichrichtungs- und Glättungsanordnung besteht, die mit ihren beiden Ausgängen an eine Diodenkaskade angeschlossen ist, und zwar mit einer Ausgangsleitung über ein steuerbares Schaltelement und mit der anderen Ausgangsleitung direkt, wobei sich zwischen den beiden Ausgangsleitungen mindestens eine der Dioden einer Diodenkaskade befindet, die die Gleichspannungsquelle bei geöffnetem Schaltelement (d.h. im ausgeschalteten Zustand) überbrückt.

Aus dieser Druckschrift ist ferner bekannt, daß zur Verringerung des durch die Gleichartigkeit der Grobstufen bedingten Quantisierungsfehlers im Ausgangssignal des Schaltverstärkers alternativ oder in Ergänzung zu der eingesetzten pulsdauermodulierten Feinstufe weitere Schaltverstärkerstufen ausgangsseitig in Reihe geschaltet werden können, die ebenfalls unabhängig voneinander ein- oder ausschaltbar sind und deren Ausgangsspannungen binär gewichtet sind, wobei die größte Ausgangsspannung gleich ist der halben Ausgangsspannung einer Grobstufe.

Weitere Schaltverstärker dieser Art sind in den vorveröffentlichten EP-0 066 904 A1 und in der bislang noch nicht veröffentlichten älteren Anmeldung P 36 35 365 der Anmelderin beschrieben.

Aus der EP-0 124 705 A1 schließlich ist ein Schaltverstärker dieser Art bekannt, bei dem eine Überwachungseinheit den Betriebszustand der einzelnen Grobstufen überwacht, indem jeweils geprüft wird, ob eine Grobstufe ein- oder ausgeschaltet ist. Muß aufgrund einer Änderung der Amplitude des Eingangssignals eine Grobstufe ein- bzw. abgeschaltet werden, veranlaßt die Überwachungseinheit über eine Rückkopplungsschleife den Steuerungsteil, daß diejenige Grobstufe ein- bzw. ausgeschaltet wird, die zuvor am längsten aus- bzw. eingeschaltet gewesen ist. Mit dieser Maßnahme wird eine gleichmäßigere Belastung der einzelnen Grobstufen während des normalen Betriebs erreicht.

Schaltverstärker dieser Art können z.B., wie in der EP-0 134 505 A1 beschrieben, als Hochspannungs-Gleichstromversorgungen z.B. in Teilchenbeschleunigeranlagen eingesetzt werden, oder, mit einem nachgeschalteten Tiefpaßfilter versehen, als Modulationsverstärker in anodenmodulierten Hochleistungs-Rundfunksendern.

Schwierigkeiten treten bei diesen bekannten Schaltverstärken beispielsweise immer dann auf, wenn eine oder mehrere Grobstufen z.B. infolge einer Störung ausfallen, d.h. auch im "eingeschalteten" Betriebszustand keinen Beitrag zum Ausgangssignal des Schaltverstärkers liefern. Beim Schaltverstärker gemäß der EP-0 124 705 A1 wird die Überwachungseinheit den Ausfall nicht registrieren, da sie nur zwischen geplant ausgeschalteten Zustand und den geplant eingeschalteten Zustand einer Grobstufe unterscheiden kann. Beim Schaltverstärker gemäß DE-30 44 956 A1 wird der Ausfall zwar registriert, jedoch wird die Steuerung zunächst versuchen, mit Hilfe der Feinstufe und/oder den weiteren Schaltverstärkerstufen mit binär gewichteten Ausgangsspannungen diesen Ausfall zu kompensieren, ehe eine weitere Grobstufe zugeschaltet wird, so daß eine verhältnismäßig lange Zeit vergeht, ehe die ausgefallene Grobstufe durch Zuschalten einer anderen Grobstufe kompensiert wird.

Weitere Schwierigkeiten treten immer dann auf, wenn für eine gegebene RF-Leistung ohne Modulation gerade nur Grobstufen allein eingeschaltet sind oder die Feinstufe zusätzlich zu fast 100 % eingeschaltet ist, da in diesen Fällen bei Netzschwankungen und/oder geringer Modulation (kleines Eingangssignal) fortlaufend eine Grobstufe ein-und ausgeschaltet werden müßte, wodurch sich zusätzliche Belastungen des Schaltverstärkers ergeben.

Die Aufgabe der Erfindung besteht daher darin, einen Schaltverstärker der eingangs genannten Art zu schaffen, der eine schnelle und genaue Kompensation von ausgefallenen Schaltverstärkerstufen ermöglicht und der ein zu häufiges Ein- und Ausschalten von Grobstufen infolge von Netzschwankungen und/oder bei fehlender oder geringer Modulation verhindert.

Die erfindungsgemäße Lösung der Aufgabe ist im Patentanspruch 1 beschrieben. Die weiteren Ansprüche enthalten vorteilhafte Aus- und Weiterbildungen der Erfindung sowie bevorzugte Anwendungen der Erfindung.

Die erfindungsgemäße Lösung besteht darin, daß in dem Leistungsteil des Schaltverstärkers eine zusätzliche Schaltverstärkerstufe (Shiftstufe) vorgesehen ist, die ausgangsseitig mit den Grobstufen und der Feinstufe in Reihe geschaltet it und unabhängig von diesen ein- und ausschaltbar ist sowie eine kleinere Ausgangsspannung ($U_{SHIFT}$) als die Grobstufen aufweist.

In einer bevorzugten vorteilhaften Ausführungsform ist die Reihenschaltung der Schaltverstärkerstufen dabei so gewählt, daß auf die in Reihe geschalteten Grobstufen die Shiftstufe und dann die Feinstufe folgt, wobei die unterste Grobstufe mit ihrem unteren Anschlußpunkt in der Reihenschaltung an Masse angeschlossen ist.

Der Steuerungsteil gibt dabei ausgangsseitig Steuerbefehle in der Weise an die Shiftstufe ab, daß sich der Schaltzustand ("ein"/"aus") der Shiftstufe immer dann ändert, wenn sich bei unveränderter Amplitude ($\Delta U = 0$) des Eingangssignals die Zahl der eingeschalteten Grobstufen geändert hat oder wenn bei einer Änderung ($\Delta U \neq 0$) der Amplitude des Eingangssignals die Änderung ($\Delta U$) kleiner ist als die Ausgangsspannung ($U_{SHIFT}$) der Shiftstufe und dabei die Summe aus gemittelter Ausgangsspannung ($U_{FEIN}$) der Feinstufe und Amplitudenänderung ($\Delta U$) den möglichen Einstellbereich ($0 - \hat{U}_{FEIN}$) der gemittelten Ausgangsspannung ($U_{FEIN}$) der Feinstufe über- oder unterschreitet. In einer vorteilhaften Ausführungsform der Erfindung ist die Ausgangsspannung ($U_{SHIFT}$) der Shiftstufe kleiner als die halbe Ausgangsspannung ($U_{GROB}$) einer Grobstufe und beträgt vorzugsweise etwa 20 % (ein Fünftel) der Ausgangsspannung ($U_{GROB}$) einer Grobstufe.

Ein weiterer erfinderischer Aspekt besteht darin, daß der Steuerungsteil eingangsseitig über eine Rückkopplungsschleife mit einer am Ausgang des Leistungsteils des Schaltverstärkers vorgesehenen Meßeinrichtung zur Messung des Ausgangssignals des Leistungsteils verbunden ist und in einem ersten Schritt durch einen Soll-Ist-Vergleich des Eingangssignals mit einem von dem Ausgangssignal des Leistungsteils abgeleiteten Meßsignals der Meßeinrichtung feststellt, ob eine (oder mehrere) der an sich zugeschalteten Grobstufen ausgefallen ist.

Für den Fall, daß ein Ausfall von einer oder mehrerer der an sich zugeschalteten Grobstufen vorliegt, gibt der Steuerungsteil des Schaltverstärkers in einen zweiten Schritt, Steuerbefehle in der Weise an die Grobstufen abzugeben, daß sich für die Zeit des Ausfalls zusätzlich eine der Zahl der an sich zugeschalteten, aber ausgefallenen Grobstufen gleiche Anzahl von bislang abgeschalteten, aber betriebsbereiten Grobstufen zuschaltet und deren Aufgabe übernimmt.

Die Vorteile der erfindungsgemäßen Lösung bestehen vor allem darin, daß der Ausfall einer oder mehrer Schaltverstärkerstufen sofort festgestellt wird und daß die Kompensation der ausgefallenen Grobstufen durch andere, betriebsbereite Grobstufen in kürzester Zeit erfolgt.

Ein weiterer Vorteil der Erfindung besteht darin, daß die Grobstufen infolge von Netzschwankungen und/oder bei fehlender oder geringer Änderung des Eingangssignals nicht mehr so häufig ein- und ausgeschaltet werden und daß sich dadurch die Belastung, vor allem die thermische Belastung, die insbesondere durch die Schaltverlustleistung in den Schaltelementen der ein- oder ausgeschalteten Grobstufen während der Schaltvorgänge bedingt ist, verringert wodurch die Ausfallswahrscheinlichkeit für die Grobstufen verringert und die Zuverlässigkeit des Schaltverstärkers erhöht wird.

Weitere Vorteile und weitere Details ergeben sich ohne weiteres aus der folgenden Beschreibung von bevorzugten Ausführungsbeispielen der Erfindung, die anhand der Figuren nun näher erläutert werden.

Ez zeigen:

FIG. 1 ein Blockschaltbild einer bevorzugten vorteilhaften Ausführungsform des erfindungsgemäßen Schaltverstärkers.

FIG. 2 ein Blockschaltbild einer bevorzugten vorteilhaften Ausführungsform des erfindungsgemäßen Steurungsteils des erfindungsgemäßen Schaltverstärkers.

FIG. 3 einen Ausschnitt aus dem erfindungsgemäßen Steurungsteil gemäß FIG. 2 mit der erfindungsgemäßen Logikschaltung.

FIG. 4 ein Flußdiagramm zur Ablaufsteuerung der Ansteuerung der Shiftstufe.

FIG. 5-6 vorteilhafte Ausführungsformen einer Schaltverstärkerstufe des erfindungsgemäßen Schaltverstärkers.

3

FIG. 7 eine bevorzugte, an sich bereits bekannte Ausführungsform der Feinstufe des erfindungsgemäßen Schaltverstärkers mit einem primärseitig geschalteten Netzgerät und einem nachgeschalteten Tiefpaßfilter.

FIG. 8 ein Blockschaltbild einer bevorzugten Ausführungsform der Steuereinheit für die Feinstufe gemäß FIG. 7.

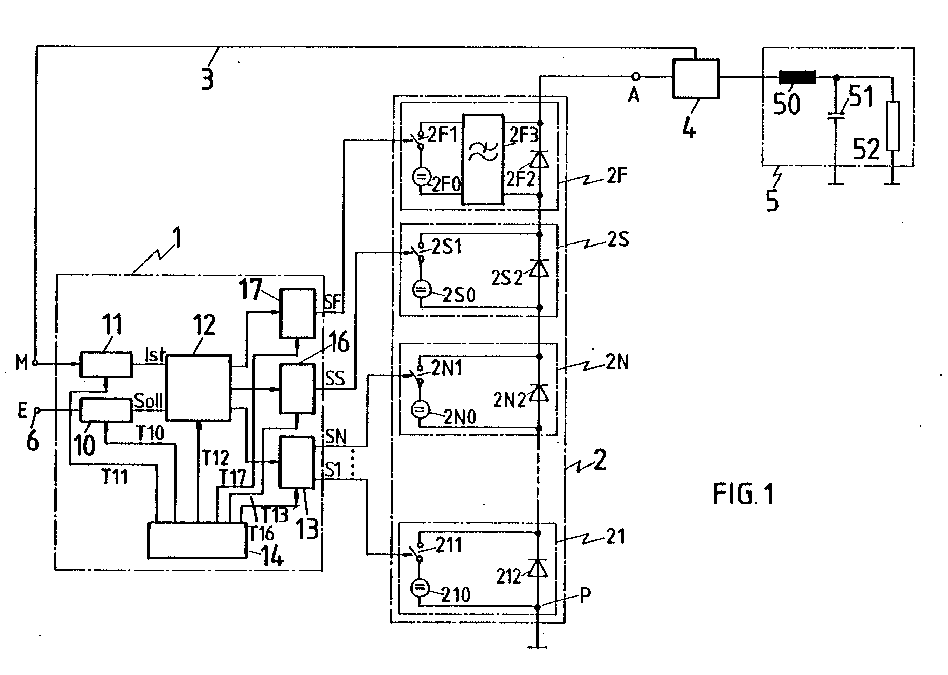

Der erfindungsgemäße Schaltverstärker in FIG. 1 besteht aus einem Steuerungsteil 1, einem Leistungsteil 2 und einer Meßeinheit 4 am Ausgang des Leistungsteils 2, die über eine Rückkopplungsschleife 3 mit einem der beiden Eingänge des Steuerungsteils 1 verbunden ist, während an dem anderen Eingang 6 des Steuerungsteils 1 das zu verstärkende analoge Eingangssignal E anliegt. Als Last 5 wurde beispielhaft ein rein ohmscher Widerstand 52 und ein vorgeschalteter LC-Tiefpaßfilter 50, 51 angenommen.

Der Leistungsteil 2 besteht aus mehreren gleichartigen Grobstufen 21...2N, einer Shiftstufe 2S und einer Feinstufe 2F, die ausgangsseitig in Reihe geschaltet sind und die jeweils eine Gleichspannungsquelle 210...2N0, 2S0 und 2F0 enthalten, die über einen Schalter 211...2N1, 2S1 und 2F1 ein- oder ausschaltbar sind und die jeweils mit ihren beiden Ausgangsleitungen an eine Diodenkaskade angeschlossen sind, und zwar die eine Ausgangsleitung direkt und die andere Ausgangsleitung über den zugehörigen Schalter 211...2N1, 2S1 und 2F1, wobei sich jeweils eine der Dioden 212...2N2, 2S2 und 2F2 der Diodenkaskade zwischen den beiden Ausgangsleitungen der zugehörigen Spannungsquelle 210...2N0, 2S0 und 2F0 befindet. In der Feinstufe 2F ist zusätzlich noch ein Tiefpaßfilter 2F3 zwischen die Gleichspannungsquelle 2F0 und Schalter 2F1 auf der einen Seite und Diode 2F2 auf der anderen Seite geschaltet. Aufgabe der Dioden 212...2N2, 2S2 und 2F2 ist es jeweils, die zugehörigen Gleichspannungsquellen 210...2N0, 2S0 und 2F0 im ausgeschaltetem Zustand, d.h. bei geöffneten Schaltern 211...2N1, 2S1, 2F1 zu überbrücken. Aufgabe des Tiefpaßfilters 2F3 in der Feinstufe 2F ist es, die durch den Schalter 2F1 pulsdauermoduliert ein-und ausgeschaltete Ausgangsspannung der Gleichspannungsquelle 2F0 zu glätten, d.h. zu mitteln, so daß am Ausgang des Tiefpaßfilters 2F3 eine mittlere Ausgangsgangsspannung $U_{FEIN}$ anliegt, die je nach Einschaltdauer der Gleichspannungsquelle 2F0 auf jeden Wert innerhalb des Einstellbereich $0-\hat{U}_{FEIN}$ eingestellt werden kann. Während die Ausgangsspannungen $U_{GROB}$ der Grobstufen 21...2N und vorzugsweise auch der Feinstufe 2F alle gleich sind, ist die Ausgangsspannung $U_{SHIFT}$ der Shiftstufe 2S kleiner als die halbe Ausgangsspannung $U_{GROB}$ einer Grobstufe 21...2N und beträgt vorzugsweise etwa 20% von $U_{GROB}$.

Die Schalter 211-2N1, 2S1 und 2F1 der einzelnen Schaltverstärkerstufen 21-2N, 2S und 2F sind über separate Steuerleitungen mit dem Steuerungsteil 1 verbunden und werden durch entsprechende Steuerbefehle S1...SN, SS und SF angesteuert, d.h. in ihrem Schaltzustand ("geschlossen") bzw. "offen" geändert, wodurch die zugehörige Schaltverstärkerstufe 21-2N, 2S bzw. 2F von dem einen zulässigen Schalt-bzw. Betriebszustand ("eingeschaltet" bzw. "ausgeschaltet") in den anderen zulässigen Schalt- bzw. Betriebszustand ("ausgeschaltet" bzw. "eingeschaltet") wechselt.

Der Steuerungsteil 1 weist eine mit drei Ausgängen und zwei Eingängen versehene Auswerteeinheit 12 auf, die ausgangsseitig jeweils mit dem Eingang einer die Steuerbefehle S1...SN bzw. SS bzw. SF erzeugenden Steuereinheit 13 für die Grobstufen 21...2N bzw. 16 für die Shiftstufe 2S bzw. 17 für die Feinstufe 2F verbunden ist.

Der eine Eingang der Auswerteeinheit 12 ist mit dem Ausgang einem ersten Signalwandler 10 verbunden, der aus dem analogen Eingangssignal E einen Sollwert in digitaler Form ableitet, der andere Eingang ist mit dem Ausgang einem weiteren Signalwandler 11 verbunden, der aus dem beispielhaft als analog erscheinenden und vom Ausgangssignal A des Schaltverstärker-Leistungsteils 2 abgeleiteten Meßsignal M der Meßeinrichtung 4 einen Istwert in digitaler Form ableitet. Sowohl der erste und zweite Signalwandler 10, 11 als auch die Auswerteeinheit 12 und die Steuereinheiten 13, 16 und 17 werden dabei von einem gemeinsamen Taktgeber 14 mit Taktsignalen T10, T11, T12, T13, T16, T17 versorgt.

In der Auswerteeinheit 12 wird der Eingangssignalbereich des Eingangssignals E in eine der Anzahl der Grobstufen 21-2N entsprechenden Zahl von gleichen Spannungsstufen unterteilt.

Während des Betriebs tastet der erste Signalwandler 10 fortlaufend in Takt T10 des Taktgebers 14 das analoge Eingangssignal E ab und leitet aus den abgetasteten momentanen Amplitudenwerten entsprechende Sollwerte in digitaler Form ab. In der Auswerteeinheit 12 wird in Takt T12 entsprechend die Zahl der zuzuschaltenden Grobstufen 21-2N bestimmt und diese Information an die Steuereinheit 13 übermittelt, die im Takt T 13 entsprechende Steuerbefehle S1-SN erzeugt, wodurch die gewünschte Zahl von Grobstufen 21-2N zugeschaltet wird. Weiterhin überprüft die Auswerteeinheit 12, ob der Sollwert mit einer der Spannungsstufen übereinstimmt oder nicht, wobei die erste Spannungsstufe der Ausgangsspannung $U_{GROB}$ einer Grobstufe entspricht und die anderen Spannungsstufen jeweils einem ganzzahligen Vielfachen dieser Ausgangsspannung $U_{GROB}$ entsprechen. Bei Nichtübereinstimmung des momentanen Sollwertes mit einer der vorgegebenen Spannungsstufen ermittelt die Auswerteeinheit 12 die einzustellende mittlere Ausgangsspannung $U_{FEIN}$ am Ausgang des Tiefpaßfilters 2F3, die erforderlich ist, daß die Differenz zwischen Ist- und Sollwert möglichst gering, im Idealfall Null ist und übermittelt diese Information an die Steuereinheit 17, die im Takt T17 entsprechende Steuersignale SF erzeugt, wodurch der Schalter SF1 mit dem der gewünschten mittleren Ausgangsspannung $U_{FEIN}$ entsprechende Tastverhältnis pulsdauermoduliert ein- und ausgeschaltet wird. Die Ausgangsspannungen der zugeschalteten Schaltverstärkerstufen addieren sich und erzeugen so das Ausgangssignal A am Ausgang des Schaltverstärkerleistungsteils 2. Die Meßeinrichtungen 4 registriert diesen Wert und leitet ein entsprechendes beispielhaft als analog angenommenes Meßsignal M ab, von dem der zweite Signalwandler 11 im Takt T11 den Istwert in digitaler Form ableitet. Die Auswerteeinheit 12 überprüft schließlich anhand von vorher festgelegten Kriterien auf der Basis von fortlaufenden Soll-Istwert-Vergleichen bzw. Sollwert(neu)-Sollwert(alt)-Vergleichen, ob der Schalt- bzw. Betriebszustand der Shiftstufe 2S zu ändern ist und übermittelt diese Information an die Steuereinheit 16, die im Takt T16 entsprechende Steuersignale SS an die Shiftstufe 2S abgibt, wodurch der Schalt- bzw. Betriebszustand der Shiftstufe 2S geändert wird. Die Taktfolgen T10, T11, T12, T13, T16, T17 sind dabei in einer bevorzugten Ausführungsform zeitlich aufeinander synchronisiert und in ihrer Frequenz gleich.

Ergibt beispielsweise der Soll-Istwert-Vergleich eine Abweichung des Istwerts vom Sollwert, wird eine entsprechende Zahl von Grobstufen eingeschaltet (Sollwert-Istwert >0) bzw. ausgeschaltet (Sollwert-Istwert <0), sofern die Abweichung von Betrage her größer ist als $U_{SHIFT}$. Bei kleineren Abweichungen bzw. bei Gleichheit wird die Zahl der eingeschalteten Grobstufen 21-2N aufrecht erhalten und wie weiter unten näher beschrieben, von der Auswerteeinheit 12 geprüft, ob der Schaltzustand der Shiftstufe 2S zu ändern ist.

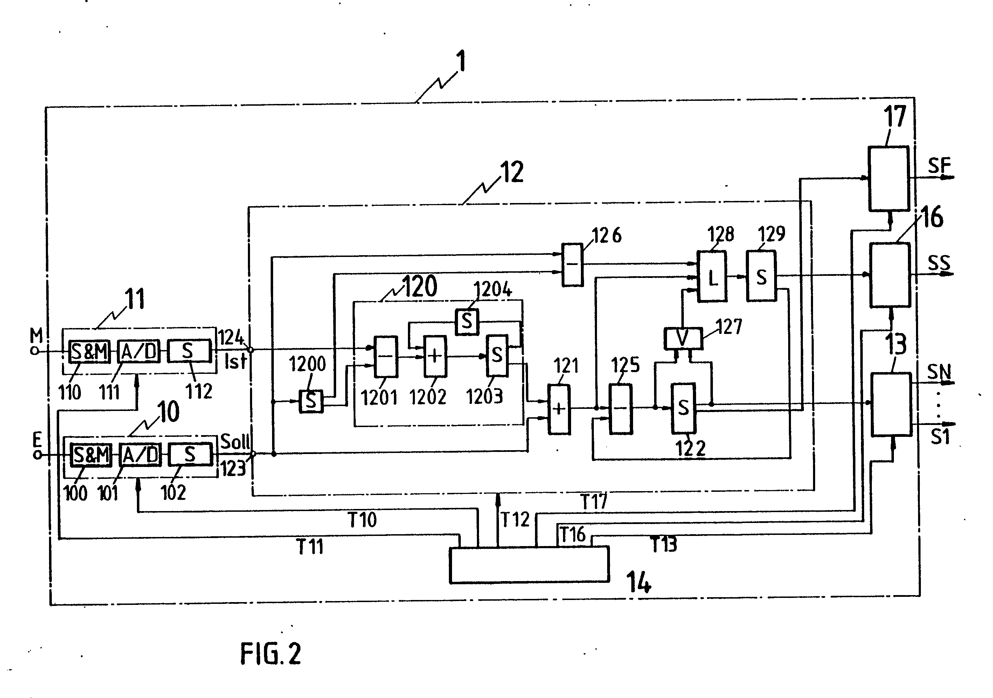

Die in FIG. 2 gezeigten bevorzugte Ausführungsform des erfindungsgemäßen Steuerteils gemäß FIG. 1 enthält den ersten Signalwandler 10 zur Umwandlung des analogen Eingangssignals E in einen digitalen Sollwert sowie den zweiten Signalwandler 11 zur Umwandlung des als analog angenommenen Meßsignals M der (nicht gezeigten) Meßeinrichtung 4. Beide Signalwandler 10 und 11 bestehen jeweils aus einer Reihenschaltung eines Sample & Hold-Verstärkers S&H 100 und 110, eines Analog/Digital-Wandlers A/D 101 und 111 sowie eines vierten und fünften Speichers S 102 und 112.

Der erste Signalwandler 10 ist ausgangsseitig an den zweiten Eingang 123 der Auswerteeinheit 12 angeschlossen, der zweite Signalwandler 11 an deren ersten Eingang 124. Ausgangsseitig ist die Auswerteeinheit 12 mit den Eingängen der Steuereinheiten 13 bzw. 16 bzw. 17 verbunden, die die Steuerbefehle S1...SN bzw. SS bzw. SF für die (nicht gezeigten) Grobstufen 21...2N bzw. die (nicht gezeigte) Shiftstufe 2S bzw. die (nicht gezeigte) Feinstufe 2F erzeugen. Der gemeinsame Taktgeber 14 versorgt die beiden Signalwandler 10 und 11, die Auswerteeinheit 12 sowie die Steuereinheiten 13, 16 und 17 mit Taktsignalen T10, T11, T12, T13, T16 bzw. T17.

Die Auswerteeinheit 12 enthält eine Logikschaltung L 128, die ausgangsseitig über einen ersten Speicher S 129 mit dem Eingang der Steuereinheit 16 für die (nicht gezeigten) Shiftstufe 2S und mit dem einen Eingang eines ersten Subtraktionsgliedes 125 verbunden ist und eingangsseitig mit den Ausgängen eines zweiten Subtraktionsgliedes 126, eines ersten Additionsgliedes 121 sowie eines Vergleichsgliedes V 127 verbunden ist.

Das zweite Subtraktionsglied 126 ist mit dem einen Eingang direkt und mit dem anderen Eingang über einen zwischengeschalteten zweiten Speicher S 1200 mit dem zweiten Eingang 123 der Auswerteeinheit 12 verbunden.

Das erste Additionsglied 121 ist ausgangsseitig zusätzlich an den anderen Eingang des ersten Subtraktionsgliedes 125 sowie mit dem einen Eingang an den Ausgang einer Soll-Istwert-Vergleichseinheit 120 und mit dem anderen Eingang direkt an den zweiten Eingang 123 der Auswerteeinheit 12 angeschlossen.

Das Vergleichsglied V 127 ist mit dem einen Eingang an den Ausgang des ersten Subtraktionsgliedes 125 und mit dem anderen Eingang an den Ausgang eines dritten Speichers S 122 angeschlossen.

Das erste Subtraktionsglied 125 ist ausgangsseitig zusätzlich über den dritten Speicher 122 zum einen mit dem Eingang der Steuereinheit 13 für die (nicht gezeigten) Grobstufen 21...2N und zum anderem mit dem Eingang der Steuereinheit 17 für die (nicht gezeigte) Feinstufe 2F verbunden.

Die Soll-Ist-Vergleichseinheit 120 ist mit ihrem ersten Eingang direkt an den ersten Eingang 124 und mit ihrem zweiten Eingang über den zweiten Speicher S 1200 an den zweiten Eingang 123 der Auswerteeinheit 12 angeschlossen.

Die Soll-Istwert-Vergleichseinheit enthält ein drittes Subtraktionsglied 1201, ein zweites Additionsglied 1202 sowie einen vierten und fünften Speicher S 1203 und 1204.

Das zweite Additionsglied 1202 ist ausgangsseitig mit dem vierten Speicher S 1203 sowie mit seinem einen Eingang mit dem fünften Speicher S 1204 und mit seinem anderen Eingang mit dem Ausgang des dritten Subtraktionsgliedes 1201 verbunden.

Der vierte Speicher S 1203 ist ausgangsseitig mit dem fünften Speicher S 1204 und dem einen Eingang des ersten Additionsgliedes 121 verbunden.

Das dritte Subtraktionsglied ist mit seinem einen Eingang direkt an den ersten Eingang 124 und mit seinem anderen Eingang über den zweiten Speicher S 1200 an den zweiten Eingang 123 der Auswerteeinheit 12 angeschlossen.

In einer bevorzugten Weiterbildung der Erfindung ist zumindest die Auswerteeinheit 12, gegebenenfalls unter Einschluß des Taktgebers 14 und der beiden Speicher 102 und 112 der beiden Signalwandler 10 und 11, mit einem Mikroprozessor oder Mini- bzw. Mikrocomputer realisiert.

In einer weiteren vorteilhaften Weiterbildung der Erfindung geschieht die Übermittlung der Steuerbefehle S1...SN, SS bzw. SF von den Steuereinheiten 13, 16 bzw. 17 zu den zugehörigen Schaltverstärkerstufen u.a. aus Gründen der Spannungsisolation und Polentialtrennung auf optoelektronischem oder direkt auf optischem Wege (z. B. mit Hilfe von Leuchtdioden, Lichtwellenleitern, Optokopplern, Fototransistoren und/oder lichtsteuerbarer Schaltern 211...2N1, 2S1, SF1 in Form von lichtzündbaren Leistungshalbleiter-Bauelementen).

Aufgabe des zweiten Subtraktionsgliedes 126 ist es, durch fortlaufenden Vergleich zweier zeitlich aufeinander folgender Sollwerte Änderungen $\Delta U$ in der Amplitude der Sollwerte bzw. des Eingangssignals E festzustellen.

Aufgabe der Soll-Istwert-Vergleichseinheit 120 ist es, fortlaufend aus einem Vergleich von Soll- und Istwert einen zur Abweichung des Istwerts von dem Sollwert proportionale Fehler-Korrekturwert abzuleiten.

Aufgabe des ersten Additionsglied 121 ist es, diesen Fehler-Korrekturwert dem Sollwert zuzuschlagen. Aus diesen korrigiertem Sollwert folgt, wieviele der Grobstufen ein- bzw. auszuschalten sind und gegebenenfalls mit welchen Tastverhältnis die Ausgangsspannung der Gleichspannungsquelle in der Feinstufe pulsdauermoduliert ein- und auszuschalten ist. Aufgabe des ersten Subtraktionsgliedes 125 ist es dabei, eine durch die Logikschaltung 128 veranlaßt eventuelle Schalt- bzw. Betriebszustandsänderung der Shiftstufe bei dieser Festlegung zu berücksichtigen.

Aufgabe des Vergleichsgliedes V 127 ist es, aus einem fortlaufenden Vergleich zweier zeitlich aufeinander folgender korrigierter Sollwerte festzustellen, ob sich die Zahl der zugeschalteten Grobstufen geändert hat.

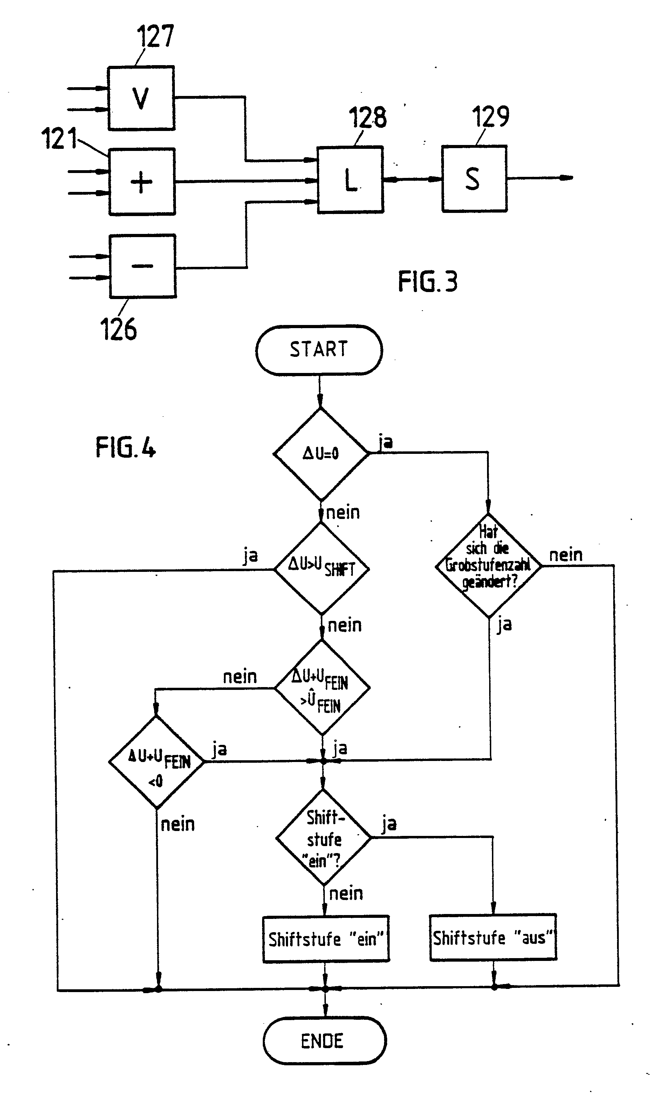

Wie FIG. 3 im Ausschnitt zeigt, besteht die Aufgabe der Logikschaltung 128 darin, die vom Substraktionsglied 126, dem ersten Additionsglied 121 und dem Vergleichsglied V 127 gelieferten Informationen über die Änderung des Sollwerts $\Delta U$, über den korrigierten Sollwert (und damit die Zahl der einzuschaltenden Grobstufen, die einzustellende mittleren Ausgangsspannungen $U_{FEIN}$ der Feinstufe) sowie über den augenblicklichen Schalt- bzw. Betriebszustand der Shiftstufe 2S nach vorgegebenen Kriterien zu bewerten und gegebenenfalls die zweite Steuereinheit 16 zu veranlassen, den Schalt- bzw. Betriebszustand der Shiftstufe zu ändern.

In FIG. 4 ist anhand eines Flußdiagramms die Ablaufsteuerung in der Auswerteeinheit 12 gemäß den Figuren 1-3 zur Festlegung des Schalt- bzw. Betriebszustands der Shiftstufe näher erläutert:

1. Zunächst wird geprüft, ob eine Änderung des Sollwertes vorliegt ($\Delta U = 0$?).

2. Liegt keine Änderung des Sollwertes vor ($\Delta U = 0$), wird der Schalt- bzw. Betriebszustand der Shiftstufe nur dann geändert, wenn sich die Zahl der eingeschalteten Grobstufen ändert.

3. Liegt eine Änderung des Sollwertes vor ($\Delta U \neq 0$), wird der Schalt- bzw. Betriebszustand der Shiftstufe nur dann geändert, wenn die Sollwertänderung kleiner ist als die Ausgangsspannung der Shiftstufe ($\Delta U < U_{SHIFT}$) und zusätzlich die Summe der Sollwertänderung $\Delta U$ und der geforderten mittleren Ausgangsspannung $U_{FEIN}$ der Feinstufe den Einstellbereich der letzteren Spannung über-oder unterschreitet ($\Delta U + U_{FEIN} > \hat{U}_{FEIN}$ bzw. $\Delta U + U_{FEIN} < 0$).

Die Funktionsweise des Steuerungsteils 1 soll um beispielhaft anhand von drei möglichen Betriebszuständen näher erläutert werden.

Zunächst sei der Fall beschrieben, daß bei einer als zeitlich konstant angenommenen Amplitude des Eingangssignals E bei sonst unveränderten Betriebsparametern eine an sich zugeschaltete Grobstufe ausfällt und sich nach einiger Zeit wieder zuschaltet.

Zunächst stimmen Ist- und Soll-Wert überein. Das dritte Subtraktionsglied 1201 ermittelt entsprechend als Differenz der beiden Werte den Wert Null. Diesem Wert wird in dem zweiten Additionsglied 1202 der zuvor von dem zweiten Additionsglied 1202 erzeugte alte Fehler-Korrekturwert (in diesem Fall ebenfalls Null) hinzuaddiert und der so erzeugte Summenwert als neuer Fehler-Korrekturwert (hier: Null) im vierten Speicher S 1203 gespeichert und vom fünften Speicher S 1204 übernommen, wobei grundsätzlich für alle Speicher S 102, 112, 122, 129, 1200, 1203, 1204 des Steuerungsteils 1 gilt, daß der oder die neu eingespeicherten Werte die zuvor gespeicherten alten Werte überschreiben, d.h. löschen. Der neue Fehler-Korrekturwert Null wird anschließend im ersten Additionsglied 121 zum Sollwert hinzuaddiert. Der so erzeugte korrigierte Sollwert wird im dritten Speicher S 122 gespeichert und veranlaßt die Steuereinheit 13, außer den bereits gemäß dem als zeitlich konstant angenommenen Sollwert eingeschalteten Grobstufen zunächst keine weiteren Grobstufen einzuschalten.

Hierbei sei vereinfachend angenommen, daß die Logikschaltung 128 keine Änderung des Schalt- bzw. Betriebszustands der Shiftstufe zu veranlassen hat, so daß die von dem ersten Additionsglied 121 ausgegebenen korrigierten Sollwerte durch das nachgeschaltete erste Subtraktionsglied 125 nicht verändert werden.

Fällt nun eine der an sich eingeschalteten Grobstufen aus, ist der von dem Ausgangssignal A über das Meßsignal M abgeleitete Istwert um einen der Ausgangsspannung $U_{GROB}$ der ausgefallenen Grobstufe proportionalen Betrag geringer als der Sollwert. Das dritte Subtraktionsglied 1201 ermittelt entsprechend einen positiven Differenzwert (Sollwert-Istwert). Das zweite Additionsglied 1202 addiert zu diesem Wert den alten Fehler-Korrekturwert (hier: Null). Das Summensignal (hier: gleich dem posititven Differenzwert) wird als neuer Fehler-Korrekturwert im vierten Speicher S 1203 gespeichert und vom fünften Speicher S 1204 übernommen sowie im ersten Additionsglied 121 zum Sollwert hinzuaddiert. Der so erzeugte korrigierte Sollwert wird im dritten Speicher S 122 gespeichert und veranlaßt die Steuereinheit 13, außer den bereits eingeschalteten Grobstufen einschließlich der an sich eingeschalteten, aber ausgefallenen Grobstufe eine weitere bislang, abgeschaltete, aber betriebsbereite Grobstufe einzuschalten, so daß in der Folge der Istwert wieder gleich ist dem Sollwert.

Das dritte Subtraktionsglied 1201 ermittelt nun den Differenzwert Null, der im zweiten Additionsglied 1202 den zuvor ermittelten positiven Differenzwert hinzuaddiert wird. Der so erzeugte neue Fehler-Korrekturwert wird im vierten Speicher S 1203 gespeichert und vom fünften Speicher S 1204 übernommen und unterscheidet sich in dem Fall nicht vom alten Fehler-Korrekturwert, so daß sich auch der korrigierte Sollwert im dritten Speicher S 122 nicht ändert und die zusätzlich eingeschaltete Grobstufe eingeschaltet bleibt.

Ist nun bei sonst unveränderten Betriebsbedingungen zu einem späteren Zeitpunkt die an sich eingeschaltete, aber ausgefallene Grobstufe wieder betriebsbereit und trägt mit ihrer Ausgangsspannung $U_{GROB}$ zum Ausgangssignal A des Schaltverstärkers bei, erhöht sich der Istwert um den entsprechenden Betrag und das dritte Subtraktionsglied 1201 ermittelt einen negativen Differenzwert (Sollwert-Istwert), der vom Betrage her gleich ist dem zuvor ermittelten positiven Differenzwert bei Ausfall der Grobstufe.

Im zweiten Additionsglied 1202 wird diesem negativen Differenzwert der im fünften Speicher S 1204 gespeicherte, vom Betrag her gleiche, aber positive alte Fehler-Korrekturwert hinzuaddiert, so daß sich als neuer Fehler-Korrekturwert der Wert Null ergibt, der im vierten Speicher S 1203 gespeichert wird und vom fünften Speicher S 1204 übernommen wird.

Im ersten Additionsglied 121 wird dieser neuer Fehler-Korrekturwet Null dem immer noch als unverändert angenommenen Sollwert hinzuaddiert, so daß sich der neue korrigierte Sollwert um den entsprechenden Betrag gegenüber dem alten korrigierten Sollwert verringert und entsprechend durch die Steuereinheit 13 eine der eingeschalteten Grobstufen wieder ausgeschaltet wird, so daß sich das Ausgangssignal A entsprechend um einen der Ausgangsspannung $U_{GROB}$ der ausgeschalteten Grobstufe entsprechenden Betrag verringert, so daß in der Folge der Istwert wieder gleich ist dem Sollwert und das dritte Subtraktionsglied 1201 als neuen Differenzwert den Wert Null ermittelt, der dem alten Fehler-Korrekturwert Null im zweiten Addidionsglied 1202 hinzuaddiert wird, so daß der neuen Fehler-Korrekturwert gleich dem alten Fehler-Korrekturwert Null ist und sich damit auch der neue korrigierte Sollwert nicht gegenüber dem vorangegangenen alten korrigierten Sollwert ändert und die Zahl der eingeschalteten Grobstufen unverändert bleibt.

Grundsätzlich ist an dieser Stelle zu bemerken, daß in dieser vorteilhaften Ausführungsform des Steuerungsteils alle Vorgänge getaktet ausgeführt werden, wobei der gemeinsame Taktgeber 14 für einen zeitsynchronen Ablauf der einzelnen Vorgänge sorgt.

In einem weiteren Fall sei nun angenommen, daß für ein gegebenes, zeitlich konstantes Ausgangssignal A gerade nur Grobstufen 21...2M (mit M = 1...N) einzuschalten sind (z.B. die Hälfte aller Grobstufen (oder weniger)) und daß die für die Versorgung der Schaltverstärkerstufen vorgesehene Netzspannung Schwankungen unterworfen ist, die zu entsprechenden Schwankungen in der Ausgangsspannung der einzelnen Gleichspannungsquellen in den einzelnen Schaltverstärkerstufen führt.

Steigt beispielsweise die Netzspannung in dem üblichen zulässigen Schwankungsbereich von typisch ±5 bis 10 % um den Nennwert an, dann würde der Steuerungsteil 1 eines Schaltverstärkers ohne Shiftstufe über den Soll-Istwert-Vergleich ermitteln, daß eine der eingeschalteten Grobstufe 21...2N auszuschalten sei und die Feinstufe 2F mit etwa 90-100 % Einschaltdauer pulsdauermoduliert ein-und auszuschalten sei.

Dabei würden unerwünschte Spannungssprünge auftreten. Sinkt die Netzspannung wieder auf den ursprünglichen Wert, würde die Feinstufe 2F wieder ausgeschaltet (Einschaltdauer 0 %) und eine der

7

ausgeschalteten Grobstufen 21...2N wieder eingeschaltet. Dieses nur durch die zulässigen Netzschwankungen hervorgerufene Ein- und Ausschalten der Grobstufen soll nun durch die Shiftstufe verhindert werden.

Sind zuerst nur Grobstufen 21...2M eingeschaltet, dann ist der Sollwert für die Feinstufe 2F Null. Steigt die Netzspannung, dann wird durch den Istwert-Sollwert-Vergleich der Vergleichseinheit 120 im ersten Additionsglied 121 vom Sollwert der entsprechende Fehler-Korrekturwert abgezogen, so daß aufgrund des neuen korrigierten Sollwertes am Ausgang der ersten Additionsgliedes 121 eine der eingeschalteten Grobstufen. 21...2N auszuschalten und die Feinstufe 2F entsprechend mit nahezu 100 % Einschaltdauer puldauermoduliert einzuschalten wäre. Durch eine Vergleich des neuen korrigierten Sollwertes mit dem vorangegangenen korrigierten Sollwert im Vergleichsglied V 127 wird ermittelt, daß sich die Anzahl der eingeschalteten Grobstufen geändert hat. Stellt nun die Logikschaltung 128 fest, daß sich diese Änderung bei $\Delta U = 0$ ergeben hat, dann wird anschließend gemäß FIG. 4 der Schalt- bzw. Betriebszustand der Shiftstufe 2S geändert, d.h. die Shiftstufe wird ausgeschaltet, wenn sie vorher eingeschaltet war bzw. eingeschaltet, wenn sie vorher ausgeschaltet war. Für den Fall, daß die Ausgangsspannung $U_{SHIFT}$ der Shiftstufe 2S etwa 20 % der Ausgangsspannung $U_{GROB}$ einer Grobstufe 21...2N beträgt, wird die Einschaltdauer der Feinstufe entsprechend um etwa 20 % auf etwa 70-80 % verringert (wenn die Shiftstufe 2S eingeschaltet wird) bzw. auf etwa 20-30 % bei zusätzlicher Einschaltung bei Grobstufenänderung (wenn die Shiftstufe 2S ausgeschaltet wird). Fällt die Netzspannung auf den ursprünglichen Wert wieder, dann bleibt trotz des entsprechenden neuen korrigierten Sollwertes die Zahl der eingeschalteten Grobstufen 21...2N konstant, während die Einschaltdauer der Feinstufe 2F um 80 % bzw. 20 % schwankt. Ist die Netzspannungsänderung so groß, daß sich die Zahl der eingeschalteten Grobstufen 21...2N ändert, ändert sich wie FIG. 4 zeigt, auch der Schalt- bzw. Betriebszustand der Shiftstufe 2S.

Geht man davon aus, daß die Schalter 211...2N1, 2S1 bzw. 2F1 mit Leistungshalbleiter-Bauelementen wie z.B. GTO-Thyristoren, Static-Induction-Thyristoren, Leistungstransistoren, MOS-Feldeffekttransistoren, Insulated-Gate-Transistoren, und/oder Kombinationen dieser Bauelemente (Kaskade bzw. Kaskode-Schaltungen usw.) realisiert werden, wird man zweckmäßigerweise die Grobstufen 21...2N mit leistungsfähigen Hochleistungs-Bauelementen wie GTO-Thyristoren oder Static-Induction-Thyristoren ausrüsten, die aber vergleichsweise lange Schaltzeiten und damit vergleichsweise hohe Schaltverlustleistungen aufweisen, während die Feinstufe 2F und insbesondere die Shiftstufe 2S mit schnellschaltenden, aber nicht so leistungsfähigen Bauelementen wie Leistungstransistoren oder MOS-Feldeffekttransisorten ausgerüstet werden können, die aufgrund der kürzeren Schaltzeiten geringere Schaltverlustleistungen aufweisen, so daß die erfindungsgemäße Lösung insbesondere unter diesen Voraussetzungen den Vorteil aufweist, daß die Grobstufen 21...2N so wenig wie möglich umgeschaltet werden und die Feinstufe 2F nicht mit maximaler Einschaltdauer von nahezu 100 % betrieben wird.

Im dritten Fall sei angenommen, daß die Feinstufe 2F bei konstantem Sollwert ($\Delta U = 0$) gerade nicht oder fast zu 100 % eingeschaltet ist, dann würde bei einem Schaltverstärker ohne Shiftstufe 2S bei kleinen Sollwertsänderungen ($\Delta U \neq 0$) fortlaufend eine der Grobstufen 21...2N ein- bzw. ausgeschaltet.

Durch Ein- oder Ausschalten der Shiftstufe 2S wird dies jedoch verhindert. Die Logikschaltung 128 wertet hierzu die Sollwertsänderung $\Delta U$ und die erforderliche mittlere Ausgangsspannung $U_{FEIN}$ der Feinstufe 2F aus (vgl. FIG. 4). Ist die Sollwertsänderung $\Delta U$ größer als die Shiftstufen-Spannung $U_{SHIFT}$, ändert sich der Schaltzustand der Shiftstufe 2S nicht. Ist die Sollwertsänderung $\Delta U$ kleiner als $U_{SHIFT}$, dann prüft die Logikschaltung 128, ob bei Addition von geforderter mittlerer Ausgangsspannung $U_{FEIN}$ der Feinstufe 2F und Sollwertsänderung $\Delta U$ der mögliche Einstellbereich der mittleren Ausgangsspannung $U_{FEIN}$, der in diesem Fall von Null bis $\hat{U}_{FEIN}$ reicht, von dem Summenwert $\Delta U + U_{FEIN}$ über-oder unterschritten wird. Ist dies nicht der Fall, ändert sich der Schaltzustand der Shiftstufe 2S nicht. Wird der Einstellbereich dagegen über- oder unterschritten, dann wird der Schaltzustand der Shiftstufe 2S geändert, wodurch sich, wie weiter oben beschrieben, die Einschaltdauer der Feinstufe 2F entsprechend ändert.

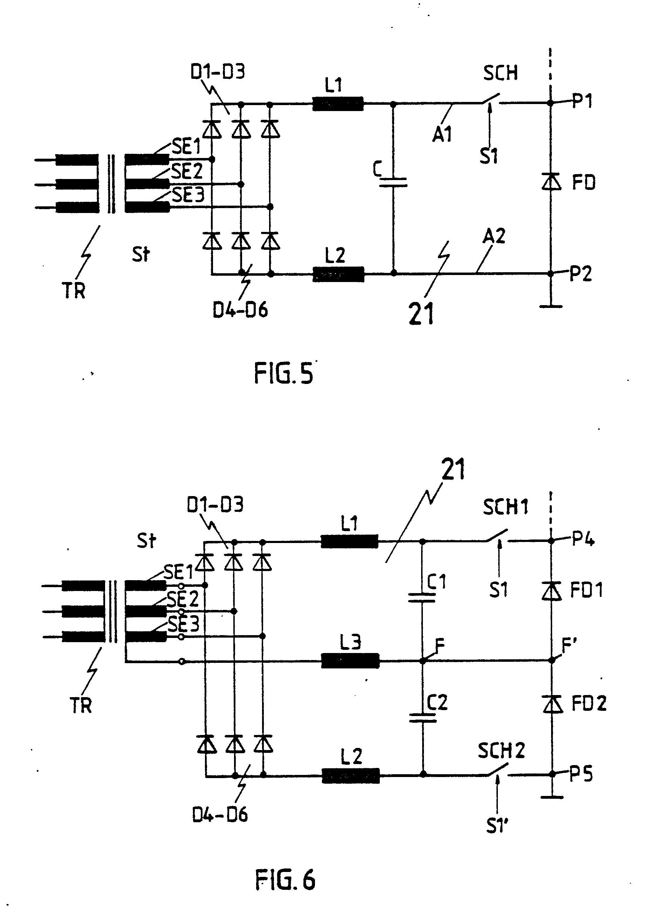

Die Figuren 5 und 6 zeigen bevorzugte vorteilhafte Ausführungsformen der einzelnen Schaltverstärkerstufen. Figur 5 zeigt am Beispiel der ersten Grobstufe 21 des Schaltver stärkers eine an sich bekannte dreiphasige Grundschaltung einer Schaltverstärkerstufe für Drehstrom, wie sie beispielsweise in leicht abgeänderter Form auch aus der DE-30 44 956 A1 bekannt ist.

Sie besteht aus einer Gleichspannungsquelle in Form eines primärseitig an das Drehstormnetz angeschlossenen Transformators TR, dem sekundärseitig eine dreiphasige Vollweg-Gleichrichteranordnung D1-D6 und eine symmetrische Glättungsanordnung L1, L2, C nachgeschaltet ist.

Die Ausgangsleitungen A1, A2 dieser Gleichspannungsquelle sind an eine Diodenkaskade angeschlossen, und zwar die eine Leitung A2 direkt und die andere Leitung A1 über ein Schalterelement SCH, das mittels des Steuerbefehls S1 der (nicht gezeigten) Steuereinheit 13 angesteuert wird. Zwischen den beiden Ausgangsleitungen A1, A2 der Stufen ist eine Diode FD der Diodenkaskade angeordnet.

Die Grobstufe wird eingeschaltet, indem der Schalter SCH geschlossen wird, und ausgeschaltet, indem der Schalter SCH geöffnet wird. Im letteren Fall dient die Diode FD als Überbrückungsdiode.

FIG. 6 zeigt eine bevorzugte Ausführungsform der verwendeten Schaltverstärkerstufen gemäß der bereits erwähnten älteren Anmeldung P 36 35 365 der Anmelderin. Auch hier wurden wie in FIG. 5 die drei (Drehstrom-) Sekundärwicklungen SF1-SE3 des Netztransformators TR mit ihren ersten Anschlüssen innerhalb des Netztransformators zu einem Sternpunkt St zusammengeschaltet.

Aus dem Transformatorengehäuse, z.B. vorzugsweise einem Öltransformator, werden vier Anschlüsse herausgeführt, nämlich die zweiten Anschlüsse der Sekundärwicklungen SE1-SE3 und der Sternpunkt St. Diese vier Herausführungen sind in der Figur durch Kreise dargestellt. An die drei zweiten Anschlüsse sind jeweils die Anoden von drei Gleichrichterdioden D1-D3 angeschlossen deren Kathoden zusammengeschaltet sind, so daß eine sogenannte Drehstrom-Stern-Gleichrichterschaltung entsteht. Die bezüglich des Sternpunktes St entstehende Roh-Gleichspannung mit einer positiven Polarität ( + ), wird über ein an die Kathoden angeschlossenes erstes LC-Siebglied, bestehend aus einer ersten Siebdrossel L1 und einem ersten Siebkondensator C1, geglättet (gesiebt).

Dabei ist der erste Siebkondensator C1 mit seinem zweiten Anschluß an den Fußpunkt F angeschlossen. Der Fußpunkt F ist über eine Zusatzdrossel L3 an den Sternpunkt St angeschlossen. Die Wirkungsweise der Zusatzdrossel L3 wird später näher erläutert. An dem ersten Siebkondensator C1 entsteht eine geglättete Gleichspannung von z.B. ungefähr 670V, die über einen durch ein Steuersignal S1 ansteuerbaren ersten Schalter SCH1 schaltbar ist und über die zu der Diodenkaskade gehörenden Diode FD1 zu den Ausgangsspannungen der anderen eingeschalteten Schaltverstärkerstufen addierbar ist.

An die zweiten Anschlüsse der Sekundärwicklungen SE1-SE3 sind außerdem die Kathoden der weiteren Gleichrichterdioden D4-D6 angeschlossen, deren Anoden zusammengeschaltet sind, so daß ebenfalls eine Drehstrom-Stern-Gleichrichterschaltung entsteht. Die bezüglich des Sternpunktes St entstehende Roh-Gleichspannung mit einer negativen Plarität (-) wird über ein an die Anoden angeschlossenes zweites LC-Siebglied, bestehend aus einer zweiten Siebdrossel L2 und einem zweiten Siebkondensator C2 geglättet. Der zweite Anschluß des zweiten Siebkondensators C2 ist mit dem Fußpunkt F verbunden.

An dem zweiten Siebkondensator C2 entsteht ebenfalls eine geglättete Gleichspannung von z.B. ungefähr 670V jedoch mit entgegengesetzter Polarität. Diese Gleichspannung ist über den durch ein Steuersignal S1 ansteuerbaren zweiten Schalter SCH2 schaltbar und über die zu der Diodenkaskade gehörende Diode FD2 ebenfalls zu den Ausgangsspannungen der anderen eingeschalteten Schaltverstärkerstufen addierbar, so daß an den Ausgängen P4, P5 eine maximale Gleichspannung von 1340V anliegen kann.

Sind die Schalter SCH1 und SCH2 geschlossen, so entsteht eine Drehstromgleichrichterbrückenschaltung, bei der bei einem 50 Hz-Netz ein Brumm mit einer Grundwelle von 300 Hz und kleiner Amplitude (4,2%eff) entsteht. Demgegenüber entsteht bei einem geöffneten Schalter (SCH1 oder SCH2) eine Drehstromsterngleichrichterschaltung, bei der ein Brumm mit einer Grundwelle von 150 Hz und großer Amplitude (18,3%eff) entsteht.

Sind nun bei einer beispielhaften Netzfrequenz von 50 Hz die beiden Schalter SCH1, SCH2 geschlossen, so entsteht an den Ausgängen P4, P5 eine Gleichspannung von z.B. 1340 V, der ein Wechselstromanteil (Welligkeit) mit einer Grundfrequenz von 300 Hz überlagert ist. Bei gleichen Bauelementen (D1 = D2 = ...D6, FD1 = FD2, L1 = L2, C1 = C2) und einer guten Siebung fließen durch die Siebkondensatoren C1, C2 lediglich vernachlässigbare Ströme. Zwischen dem Fußpunkt F und dem Sternpunkt St fließt kein Strom oder ein ebenfalls vernachlässigbarer Strom über die Zusatzdrossel L3. Wird nun einer der beiden Schalter SCH1, SCH2 geöffnet, so entsteht an den Ausgängen P4, P5 eine Gleichspannung von z.B. 670V, der jedoch ein Wechselstromanteil mit einer Grundfrequenz von 150 Hz überlagert ist. In diesem Falle wird die Zusatzdrossel L3 automatisch wirksam. Es entsteht eine bessere Siebung und eine gute Entkopplung zwischen dem (Versorgungs-)Netz und der geschalteten bzw. modulierten Gleichspannung. Eine Entkopplung ist immer dann gegeben, wenn über Zusatzdrossel L3 und eine der Siebdrosseln L1 oder L2 ein Spannungsabfall vorhanden ist. Dann fließt immer ein erwünschter Ladestrom in einen der Siebkondensatoren C1 oder C2.

Dazu müssen die Zusatzdrossel L3 und eine der Siebdrosseln zusammen eine Induktivität L besitzen gemäß der Formel

$$L \geq \frac{\sqrt{2} \cdot \tilde{U}_{oeff}}{2\pi \cdot p \cdot f \cdot I_o},$$

dabei bedeuten $\tilde{U}_{oeff}$ die effektive Spannung der Welligkeit

p die Pulszahl der Gleichrichterschaltung

f die Netz- oder Schaltfrequenz

$I_o$ den minimalen Laststrom durch einen zwischen den Anschlüssen P4, P5 angeschlossenen Lastwiderstand 5 (FIG. 1).

Bei geschlossenen Schaltern SCH1 und SCH2 ist die gleiche Entkopplung vorhanden, wenn an den Siebdrosseln L1 und L2 ein Spannungsabfall entsteht. Die Zusatzdrossel L3 ist in diesem Falle unwirksam. Die Induktivität der Summe der beiden Siebdrosseln L1, L2 muß dabei ebenfalls die Bedingungen der erwähnten Formel erfüllen.

Aus der Formel ist ersichtlich, daß bei einem unabhängigen Schalten sich $U_{oeff}$ vergrößert und die Pulszahl p von dem Wert 6 auf den Wert 3 erniedrigt wird. Aus der Formel ist außerdem ersichtlich, daß durch die Zusatzdrossel L3 in erwünschter Weise die Welligkeit verringert und ein Ladestrom durch die Siebkondensatoren aufrechterhalten wird.

Werden mehrere solcher Schaltverstärkerstufen in Reihe geschaltet, um beispielhaft eine an der Last 5 anliegende Gleichspannung von ungefähr 32 KV zu erzeugen, sind vorteilhafterweise für 48 Schaltverstärkerstufen lediglich 24 Drehstromsekundärwicklungen erforderlich. Die Anzahl der aus dem Netztransformator herauszuführenden Anschlüsse (Anzahl der Herausführungen) beträgt 4 x 24 = 96 (gegenüber 144 gemäß FIG. 3).

Benutzt man nun für die Gleichrichtung einen sogenannten 12-Puls-Betrieb, daß heißt man verwendet zwei 3-Phasen-Drehstrom-Netztransformatoren, von denen einer primärseitig im Stern und der andere primärseitig im Dreieck geschaltet ist, so ergeben sich 96 : 2 = 48 Herausführungen pro Netztransformator TR. Diese Anzahl ist auch bei einem Öltransformator technisch und wirtschaftlich herstellbar. Denn die Anzahl ist z.B. auf sehr hochspannungsfeste, sogenannte Stützer verteilbar, die jeweils acht Herausführungen aufnehmen.

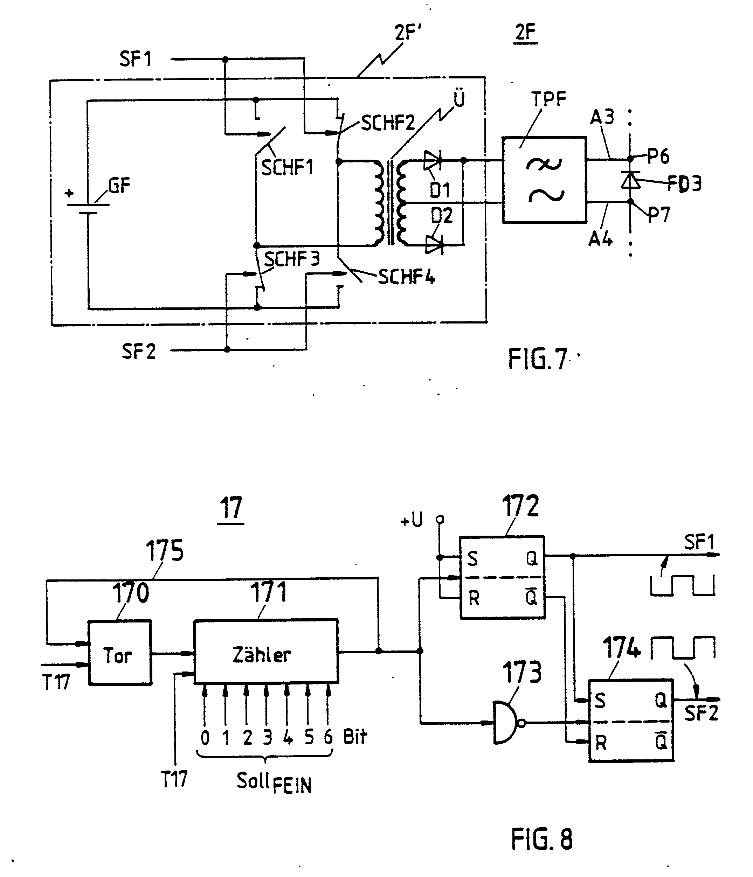

In FIG. 7 ist eine bevorzugte, an sich bereits bekannte (DE-35 38 661 A1) Ausführungsform der Feinstufe 2F des erfindungsgemäßen Schaltverstärkers gezeigt mit einem primärseitig geschalteten Schaltnetzteil 2F', dem ausgangsseitig ein Tiefpaßfilter TPF und eine Überbrückungsdiode FD 3 der Diodenkaskade nachgeschaltet ist. Das Schaltnetzteil 2F' besteht in an sich bekannter Weise aus einer Gleichspannungsquelle GF, einer Vollbrücken-Schalteranordnung SCHF1-SCHF4, einem Überträger Ü und Gleichrichteranordnung D1-D2. Die Schalter SCHF1-SCHF4 werden über Steuerleitungen durch zueinander komplementäre Steuersignale SF1 und SF2 im Gegentakt angesteuert, d.h. die Schalter SCHF1 und SCHF4 befinden sich immer im gleichen Schalt- bzw. Betriebszustand, der komplementär zum Schalt- bzw. Betriebszustand der anderen beiden Schalter SCHF2 und SCHF3 ist (vgl. auch die Schalterstellung in der FIG. 7).

In FIG. 8 ist eine bevorzugte Ausführungsform der Steuereinheit 17 für die Feinstufe 2F gemäß FIG. 7 gezeigt.

Ein programmierbarer Vorwärts-Rückwärtszähler 171 wird auf den der geforderten mittleren Ausgangsspannung $U_{FEIN}$ der Feinstufe 2F entsprechenden digitalen Sollwert $Soll_{FEIN}$ eingestellt. Danach wird ein Tor 170 geöffnet, über das der Zähler 171 mit Taktimpulsen T17 auf Null zurückzählt. Bei Null gibt der Zähler 171 ein Signal über die Leitung 175 an das Tor 170 ab, mit dem das Tor 170 geschlossen wird. Die Öffnungszeit des Tores 170 ist identisch mit der Einschaltzeit der Feinstufe 2F'. Je höher der digitale Sollwert $Soll_{FEIN}$ ist, um so länger ist die Zählzeit des Zählers 171 und damit die Einschaltzeit der Feinstufe 2F'. Die Frequenz des Taktsignals T17 ist dabei so zu wählen, daß die höchste Zahl der digitalen Einstellung im Zähler 171 gerade zwischen den Taktimpulsen T10 des A/D-Wandlers 101 des ersten Signalwandlers 10 gemäß FIG. 1 oder 2 gezählt werden kann. Beträgt z.B. der Einstellbereich der Feinstufe 7 Bit $\triangleq 2^7 = 128$ und beträgt die Frequenz des Taktsignals T10 für den A/D-Wandler 101 z.B. 100 KHz (entspricht einer Wandlungszeit von (10μsec), so ist die Frequenz des Taktsignals T17 zu

$$\frac{128}{10 \cdot 10^{-6} \, sec}$$

= 12.8 MHz zu wählen.

Mit den Signalen des Zählers 171 werden ein erstes Flip-Flop 172 direkt und ein zweites Flip-Flop 174 über ein Inverter 173 angesteuert. Das erste Flip-Flop 172 wird dabei von der positiven Flanke des pulsdauermodulierten Signals (PDM-Signals) getriggert und das zweite Flip-Flop 174 von der negativen Flanke. Durch die Verkopplung der Ausgänge Q bzw. $\overline{Q}$ des ersten Flip-Flops 172 mit den Setz- bzw. Rücksetzeingängen S bzw. R des zweiten Flip-Flops 174 kippt das zweite Flip-Flop 174 in die Lage des ersten Flip-Flops 172. Dabei haben die Ausgangssignale Q der beiden Flip-Flops 172 und 174 bei hoher Modulationsfrequenz ein von 1:1 etwas abweichendes Tastverhältnis.

Es versteht sich, daß die Erfindung mit fachmännischem Können und Wissen aus- und weitergebildet sowie an die unterschiedlichen Anwendungen angepaßt werden kann, ohne daß dies hier an dieser Stelle näher erläutert werden müßte.

So ist es z.B. möglich, daß das Meßsignal M der Meßeinrichtung und/oder das Eingangssignal E bereits in digitaler Form vorliegen, so daß die beiden Signalwandler in dem Steuerungsteil entfallen und das Meßsignal M als Istwert und das Eingangssignal E als Sollwert direkt den entsprechenden Eingängen der Auswerteeinheit zugeführt werden.

Ferner sind andere Ausführungsformen der Schaltverstärkerstufen denkbar (z.B. unter Verwendung von Spannungsverdopplungs- bzw. Spannungs-Vervielfacherschaltungen als Gleichrichteranordnungen in den Gleichspannungsquellen).

Schließlich ist es möglich, zur Verringerung des durch die Gleichartigkeit der Schaltverstärkerstufen bedingten Quantisierungsfehler im Ausgangssignal A des Schaltverstärkers im ersteren Leistungteil einen weiteren Leistungteil mit den anderen Schaltverstärkerstufen in Reihe zu schalten, wobei dieser weitere Leistungteil in seiner Ausgangsspannung gemäß dem Quantisierungsfehler in Stufen einstellbar ist z.B. (wie in der DE-30 44 956 A1 bereits beschrieben) in Form einer Reihenschaltung von mehreren unabhängig voneinander ein- oder ausschaltbaren Schaltverstärkerstufen mit binär gewichteten Ausgangsspannungen.

## Ansprüche

1. Schaltverstärker zur digitalen Leistungsverstärkung eines analogen Eingangssignals, mit einem Leistungs- und einem Steuerungsteil, welcher Leistungteil mehrere gleichartige Schaltverstärkerstufen (Grobstufen) sowie eine weitere Schaltverstärkerstufe (Feinstufe) enthält, die ausgangsseitig in Reihe geschaltet sind und unabhängig voneinander ein- bzw. ausschaltbar sind, und welcher Steuerungsteil den Eingangssignalbereich in eine der Anzahl der Grobstufen entsprechende Zahl von gleichen Spannungsstufen unterteilt, das Eingangssignal fortlaufend abtastet und ausgangsseitig Steuerbefehle in der Weise an die Schaltverstärkerstufen abgibt, daß bei einer Änderung der Amplitude des Eingangssignals um eine Spannungsstufe nach oben bzw. nach unten sich eine Grobstufe in der Reihenschaltung ein- bzw. ausschaltet, und daß bei Nicht übereinstimmung der geänderten Amplitude des Eingangssignals mit einer der vorgegebenen Spannungsstufen sich die Feinstufe in Abhängigkeit von der Differenz zwischen der geänderten Amplitude des Eingangssignals und der ihr am nächsten liegenden kleineren Spannungsstufe pulsdauermoduliert ein- und ausschaltet, dadurch gekennzeichnet,
- daß der Leistungteil (2) eine zusätzliche Schaltverstärkerstufe (Shiftstufe) (2S) aufweist, die ausgangsseitig mit den Grobstufen (21-2N) und der Feinstufe (2F) in Reihe geschaltet ist und unabhängig von diesen ein- bzw. ausschaltbar ist sowie eine kleinere Ausgangsspannung ($U_{SHIFT}$) als die Grobstufen (21-2N) aufweist;
- daß der Steuerungsteil (1) ausgangsseitig Steuerbefehle (SS) in der Weise an die Shiftstufe (2S) abgibt, daß sich der Schaltzustand ("ein"/"aus") der Shiftstufe (2S) ändert, wenn sich bei unveränderter Amplitude ($\Delta U = 0$) des Eingangssignals (E) die Zahl der eingeschalteten Grobstufen (21-2N) geändert hat oder wenn bei einer Änderung ($\Delta U \neq 0$) der Amplitude des Eingangssignals (E) die Änderung ($\Delta U$) kleiner ist als die Ausgangsspannung ($U_{SHIFT}$) der Shiftstufe (2S) und die Summe aus gemittelter Ausgangsspannung ($U_{FEIN}$) der Feinstufe (2F) und Amplitudenänderung ($\Delta U$) den möglichen Einstellbereich ($0\text{-}\hat{U}_{FEIN}$) der gemittelten Ausgangsspannung ($U_{FEIN}$) der Feinstufe (2F) über-oder unterschreitet.

2. Schaltverstärker nach Anspruch 1, dadurch gekennzeichnet, daß die Reihenschaltung der Schaltverstärkerstufen (21-2N, 2S, 2F) so gewählt ist, daß auf die in Reihe geschalteten Grobstufen (21-2N) die Shiftstufe (2S) und dann die Feinstufe (2F) folgt.

3. Schaltverstärker nach Anspruch 2, dadurch gekennzeichnet, daß die erste Grobstufe (21) in der Reihenschaltung der Schaltverstärkerstufen (21-2N, 2S, 2F) mit ihrem äußeren Anschlußpunkt (P; P2; P5) in der Reihenschaltung an Masse angeschlossen ist.

4. Schaltverstärker nach einem der Ansprüche 1 bis 3, dadurch gekennzeichnet, daß die Ausgangsspannung ($U_{SHIFT}$) kleiner ist als die halbe Ausgangsspannung ($U_{GROB}$) einer Grobstufe (21-2N) und vorzugsweise etwa ein Fünftel der Ausgangsspannung ($U_{GROB}$) einer Grobstufe (21-2N) beträgt.

11

5. Schaltverstärker nach einem der Ansprüche 1 bis 4, dadurch gekennzeichnet, daß die Mehrzahl oder alle der Schaltverstärkerstufen (21-2N, 2S, 2F) jeweils in Form eines sekunddärseitig geschalteten Netzgeräts mit einem primärseitig an das Netz angeschlossene Transformator (TR) und einer sekundärseitig nachgeschalteten Gleichrichter- und Glättungsanordnung (D1-D6, L1-L2, C), mit mindestens einer zwischen die Ausgänge der Gleichrichter- und Glättungsanordnung (D1-D6, C1-C2, C) geschalteten Überbrückungsdiode (FD) und mit mindestens einem steuerbaren Schalter (SCH) in einer der beiden Ausgangsleitungen (A1, A2) der Gleichrichter- und Glättungsanordnung (D1-D6, L1-L2, C), wobei die Überbrückungsdioden (FD) der ein zelnen Schaltverstärkerstufen (21-2N) zu einer Diodenkaskade in Reihe geschaltet sind.

6. Schaltverstärker nach Anspruch 5, dadurch gekennzeichnet, daß in der Feinstufe (2F) zwischen Gleichspannungsquelle (2FQ) und Schalter (2F1) auf der einen Seite und Überbrückungsdiode (2F2) auf der anderen Seite ein Tiefpaßfilter (2F3) geschaltet ist.

7. Schaltverstärker nach Anspruch 5, dadurch gekennzeichnet, daß die Feinstufe (2F) als primärseitig geschaltetes Netzgerät (2F') mit nachgeschaltetem Tiefpaßfilter (TPF) ausgebildet ist, daß zwischen den beiden Ausgangsleitungen (A3, A4) des Tiefpaßfilters (TPF) mindestens eine Überbrückungsdiode (FD3) geschaltet ist und daß die Überbrückungsdiode (FD3) Teil der Diodenkaskade ist.

8. Schaltverstärker nach Anspruch 5, dadurch gekennzeichnet, daß die einzelnen Grobstufen (21-2N) jeweils in Form eines sekundärseitig geschalteten Doppelnetzgeräts zumindest bestehend aus einem Drehstromtransformator mit drei Sekundärwicklungen (SE1-SE3), deren erste Anschlüsse zu einem Sternpunkt (St) zusammengeschaltet sind und deren zweite Anschlüsse mit zwei Drehstrom-Stern-Gleichrichterschaltungen (D1-D3 sowie D4-D6) angeschlossen sind, die bezüglich des Sternpunktes (St) zwei Gleichspannungen mit unterschiedlicher Polarität erzeugen,
- daß jede Gleichspannung durch jeweils ein LC-Sieb glied (L1, C1 sowie L2, C2) geglättet wird,
- daß die Siebkondensatoren (C1, C2) der LC-Siebglieder einen gemeinsamen Fußpunkt (F) besitzen, der über eine Zusatzdrossel (L3) mit dem Sternpunkt (St) verbunden ist,
- daß die Zusatzdrossel (L3) eine Induktivität besitzt derart, daß bei unabhängig voneinander betätigten Schaltern (SCH1, SCH2) der Laststrom durch die Zusatzdrossel (L3) fließt und
- daß die Gleichspannungen über mindestens zwei hintereinandergeschaltete Dioden (FD1, FD2), deren gemeinsamer Anschluß (F') mit dem Fußpunkt (F) der Siebkondensatoren (C1, C2) verbunden ist, addierbar sind.

9. Schaltverstärker nach einem der Ansprüche 1 bis 8, dadurch gekennzeichnet,
- daß zur Ableitung eines digitalen Istwerts am Ausgang des Leistungsteils (2) des Schaltverstärkers eine Meßeinrichtung (4) zur Messung des Ausgangssignals (A) des Schaltverstärkers vorgesehen ist;
- daß der Ausgang der Meßeinrichtung (4) über eine Rückkopplungsschleife (3) mit einem ersten Eingang (124) einer Auswerteeinheit (12) des Steuerteils (1) verbunden ist;
- daß die Anschlußklemme (6) für das analoge Eingangssignal (E) über einen ersten Signalwandler (10) zur Wandlung des Eingangssignals (E) in einen digitalen Sollwert mit einem zweiten Eingang (123) der Auswerteeinheit (12) des Steuerteils (1) verbunden ist;
- daß die Auswerteeinheit (12) ausgangsseitig mit einer ersten Steuereinheit (13) zur Ansteuerung der Grobstufen (21-2N), mit einer zweiten Steuereinheit (16) zur Ansteuerung der Shiftstufe (2S) und mit einer dritten Steuereinheit (17) zur Ansteuerung der Feinstufe (2F) verbunden ist und daß die Steuereinheiten (13, 16, 17) über Steuerleitungen die Steuerbefehle (S1...SN; SS, SP) an die zugehörigen Schaltverstärkerstufen (21-2N; 2S; 2F) abgeben;
- daß die Auswerteeinheit (12) fortlaufend Soll- und Istwert bzw. den neuen Sollwert mit dem vorangegangenen alten Sollwert vergleicht und anhand der gewonnenen Ergenisse in einer Logikschaltung L (128) gemäß vorgegebener Kriterien prüft, ob der Schaltzustand der Shiftstufe (2S) zu ändern ist.

10. Schaltverstärker nach Anspruch 9, dadurch gekennzeichnet, daß bei analogen Meßsignalen (M) der Meßeinrichtung (4) die Rückkopplungsschleife (3) einen zweiten Signalwandler (11) zur Wandlung des Meßsignals (M) in einen digitalen Istwert enthält.

11. Schaltverstärker nach einem der Ansprüche 9 bis 10, dadurch gekennzeichnet, daß die Prozesse im Steuerungsteil (1) zeitsynchron getaktet ablaufen und daß hierfür ein gemeinsamer Taktgeber (14) für die Signalwandler (10, 11), die Auswerteeinheit (12) und die Steuereinheiten (13, 16, 17) vorgesehen ist.

12. Schaltverstärker nach einem der Ansprüche 9 bis 11, dadurch gekennzeichnet,
- daß die Logikschaltung L (128) ausgangsseitig über einen ersten Speicher S (129) mit dem Eingang der zweiten Steuereinheit (16) für die Shiftstufe (2S) und mit dem einem Eingang eines ersten Subtraktionsgliedes (125) verbunden ist und eingangsseitig mit den Ausgängen eines zweiten Subtraktionsgliedes (126) eines ersten Additionsgliedes (121) sowie eines Vergleichsgliedes V (127) verbunden ist;
- daß das zweite Subtraktionsglied (126) mit dem einem Eingang direkt und mit dem anderen Eingang über einen zwischengeschalteten zweiten Speicher S (1200) mit dem zweiten Eingang (123) der Auswerteeinheit (12) verbunden ist;

- daß das erste Additionsglied (121) ausgangsseitig zusätzlich an den anderen Eingang des ersten Subtraktionsgliedes (125) sowie mit dem einem Eingang an den Ausgang einer Soll-Istwert-Vergleichseinheit (120) und mit dem anderem Eingang direkt an den zweiten Eingang (123) der Auswerteeinheit (12) angeschlossen ist;

- daß das Vergleichsglied V (127) mit dem einem Eingang an den Ausgang des ersten Subtraktionsgliedes (125) und mit dem anderen Eingang an den Ausgang eines dritten Speichers S (122) angeschlossen ist;

- daß das erste Subtraktionsglied (125) ausgangsseitig zusätzlich über den dritten Speicher S (122) zum einen mit dem Eingang der ersten Steuereinheit (13) für die Grobstufen (21...2N) und zum anderen mit dem Eingang der dritten Steuereinheit (17) für die Feinstufe (2F) verbunden;

- daß die Soll-Istwert-Vergleichseinheit (120) mit ihrem ersten Eingang direkt an den ersten Eingang (124) und mit ihrem zweiten Eingang über den zweiten Speicher S (1200) an den zweiten Eingang (123) der Auswerteeinheit (12) angeschlossen ist.

13. Schaltverstärker nach Anspruch 12, dadurch gekennzeichnet,

- daß die Soll-Istwert-Vergleichseinheit (120) ein drittes Subtraktionsglied (1201), ein zweites Additionsglied (1202) sowie einen vierten und fünften Speicher S (1203, 1204) enthält;

- daß das zweite Additionsglied (1202) ausgangsseitig mit dem vierten Speicher S (1203) sowie mit seinem einen Eingang mit dem fünften Speicher S (1204) und mit seinem anderen Eingang mit dem Ausgang des dritten Subtraktionsgliedes (1201) verbunden ist;

- daß der vierte Speicher S (1203) ausgangsseitig mit dem fünften Speicher S (1204) und dem einen Eingang des ersten Additionsglieds (121) verbunden ist;

- daß das dritte Subtraktionsglied (1201) mit dem einen Eingang direkt an den ersten Eingang (124) und mit dem anderen Eingang über den zweiten Speicher S (1200) an den zweiten Eingang (123) der Auswerteeinheit (12) angeschlossen ist;

14. Schaltverstärker nach einem der Ansprüche 9 bis 13, dadurch gekennzeichnet, daß der erste und/oder gegebenenfalls auch der zweite Signalwandler (10, 11) jeweils als Reihenschaltung aus Sample & Hold-Verstärker (100, 110), Analog/Digital-Wandler (101, 111) und fünften bzw. sechsten Speicher S (102, 112) ausgebildet ist.

15. Schaltverstärker nach einem der Ansprüche 9 bis 14, dadurch gekennzeichnet, daß zumindest die Auswerteeinheit (12) gegebenenfalls unter Einschluß des Taktgebers 14 und der beiden Speicher S (102, 112) der Signalwandler (10, 11), mit einem Mikroprozessor oder Mikro- bzw. Minicomputer realisiert ist.

16. Schaltverstärker nach einem der Ansprüche 1 bis 15 dadurch gekennzeichnet, daß die Übermittlung der Steuerbefehle (S1...SN; SS; SF) von den Steuereinheiten (13, 16, 17) zu den zugehörigen Schaltverstärkerstufen (21-2N; 2S; 2F) auf optoelektronischem Wege oder direkt auf optischem Wege erfolgt.

17. Schaltverstärker nach einem der Ansprüche 1 bis 16, dadurch gekennzeichnet, daß der Meßeinheit (4) am Ausgang des Schaltverstärkers ein Tiefpaßfilter (40, 41) zur Glättung des Ausgangssignals (A) des Schaltverstärkers nachgeschaltet ist.

18. Schaltverstärker nach einem der Ansprüche 1 bis 17, gekennzeichnet durch die Anwendung als Hochspannungs-Gleichstromversorgung.

19. Schaltverstärker nach Anspruch 17, gekennzeichnet durch die Anwendung in einem Modulationsverstärker für einen anodenmodulierten Hochleistungssender.

FIG.1

FIG. 2

EP 0 327 682 A1

**FIG.3**

**FIG.4**

FIG.5

FIG.6

FIG.7

FIG. 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 403 197 (H.I. SWANSON) <br> * Figuren 1-3; Zusammenfassung; Spalte 8, Zeile 56 - Spalte 9, Zeile 32 * & DE-A-3 044 956 (Kat. D,A) <br> ----- | 1-3 | H 03 F 3/217 |

RECHERCHIERTE
SACHGEBIETE (Int. Cl.4)

H 03 F

Der vorliegende Recherchenbericht wurde für alle Patentansprüche erstellt

| Recherchenort | Abschlußdatum der Recherche | Prüfer |
|---|---|---|
| DEN HAAG | 17-05-1989 | TYBERGHIEN G.M.P. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes
Dokument